# EUROPEAN PATENT APPLICATION

(11) **EP 2 587 180 A1**
(43) Date of publication of application: **01.05.2013**
(21) Application number: 12190532.7
(22) Date of filing: 30.10.2012
(51) Int. Cl.: F24F 13/32, E04F 15/024, H05K 7/20

(54) **Auxiliary module for raised floors for removing fans, arranged under the floor, of climate control machines**

(30) Priority: 31.10.2011 IT PD20110345
(71) Applicant: Emerson Network Power S.R.L., 35028 Piove di Sacco (PD) (IT)
(72) Inventor: De Zen, Daniele, 35020 Correzzola PD (IT)
(74) Representative: Modiano, Micaela Nadia

(57) **Abstract**

An auxiliary module (10) for raised floors for removing fans, arranged under the floor, of climate control machines, which comprises a framework (11) with legs (12) the height of which can be adjusted to adapt to the height of a raised floor (P), and feet (13) for resting on the ground, and at least one flat resting element (14), the framework forming:
- a first frame (17) for supporting the at least one, upper, flat resting element (14), which is formed at such a height as to allow the flat resting element (14) to support one or more panels (P1, P2) of a raised floor (P),
- a second, lower, supporting frame (18), which is formed at a height that is intermediate between the first supporting frame (17) and the ground, so as to allow the resting on the flat resting element (14) of a fan (V) removed from its seat (S) below a climate control machine (M),

the at least one flat resting element (14) being arrangeable on either one of the first and second supporting frames (17, 18).

## Description

The present invention relates to an auxiliary module for raised floors for removing fans, arranged under the floor, of climate control machines.

Server rooms, and in general any site that contains numerous electronic devices and racks for supporting a plurality of servers, electrical and electronical instruments and the like, generally enclosed within adapted ventilated cabinets, require a continuous climate control that is adapted to prevent the heat originating from the computers and from the electronical instruments themselves from accumulating and thus causing temperatures that are so high as to damage the internal components of such electronical instruments and the like.

Nowadays, in order to overcome these drawbacks, floor climate control plants are generally installed in server rooms, and are increasingly widespread particularly in environments installed on a raised floor.

In fact the space between the ground and the raised floor can be easily fitted out not only for the distribution of cables for connecting and powering the racks and computers, but also as a plenum space, i.e. as an area for the passage of conditioned air, fed in by one or more cooling and climate control machines, such plenum spaces conveying the air, by way of floor grilles, either to the overlying environment or directly into the rack cabinets.

Machines for such climate control are generally constituted by a cabinet within which heat exchange means are arranged below which there are, generally arranged, in whole or in part, below the raised floor, a plurality of fans which are designed to aspirate air from the upper part of the cabinet so that it crosses the heat exchange means and is then pushed, treated, into the underfloor space.

Such a cooling and climate control system, although very widespread and appreciated, exhibits some drawbacks.

One such drawback is determined by the underfloor position of such fans, the removal of which, for repairs or ordinary maintenance, is very inconvenient.

In fact, nowadays, in order to remove the fans it is necessary to dismantle and remove the structure of the raised floor, which comprises numerous posts and feet arranged in the area in front of the machine.

Sometimes the feet of the structures of raised floors are screwed into or glued to the floor, and the removal can be difficult and can sometimes necessitate the replacement of the feet if they have been glued to the ground.

Moreover, once the posts and feet have been removed, extraction of the fan is inconvenient since the operator has no intermediate resting surface between the ground and the raised floor where the fan extracted from the seat under the climate control machine can be rested, the fan often being heavy and in any case inconvenient to handle when being lifted from below the floor to above the floor.

The aim of the present invention is to provide an auxiliary module for raised floors for removing fans, arranged under the floor, of climate control machines, which makes it possible to overcome the above mentioned drawbacks of the known art.

Within this aim, an object of the invention is to provide an auxiliary module that enables the quick and easy removal and repositioning of the bladed and motorized impeller part, without the inconvenient operations of disassembly and reassembly of posts and feet for supporting the raised floor.

Another object of the invention is to provide an auxiliary module that frees the operator from having to work for a long period in uncomfortable positions.

Another object of the invention is to provide an auxiliary module which can be easily associated with conventional frames of climate control machines and the like.

Another object of the invention is to provide an auxiliary module for raised floors for removing fans, arranged under the floor, of climate control machines, which can be made using conventional systems and technologies.

This aim and these and other objects which will become more apparent hereinafter are all achieved by an auxiliary module for raised floors for removing fans, arranged under the floor, of climate control machines, which is **characterized in that** it comprises
- a framework with legs the height of which can be adjusted to adapt to the height of a raised floor, and feet for resting on the ground, said framework having
- at least one flat resting element,
said framework forming
- a first frame for supporting said at least one, upper, resting element, which is formed at such a height as to allow said flat resting element to support one or more panels of the raised floor,
- a second, lower, supporting frame, which is formed at a height that is intermediate between the first supporting frame and the ground, so as to allow the resting on said flat resting element of a fan removed from its seat below a climate control machine,
said at least one flat resting element being arrangeable on either one of said first and second supporting frames.

Further characteristics and advantages of the invention will become more apparent from the description of a preferred, but not exclusive, embodiment of the auxiliary module according to the invention, which is illustrated by way of non-limiting example in the accompanying drawings wherein:
Figure 1 is a perspective view of an auxiliary module according to the invention, which is associated with a climate control machine;
Figure 2 is a perspective view of the auxiliary module according to the invention in a first configuration of use;
Figure 3 is a perspective view of an auxiliary module according to the invention in a second configuration of use.

With reference to the figures, an auxiliary module for raised floors for removing fans, arranged under the floor, of climate control machines, according to the invention, is generally designated with the reference numeral 10.

A generic climate control machine with fans arranged below a raised floor is designated with M, a generic fan is designated with V, the raised floor is designated with P, the panels that make up the raised floor are designated, for the purposes of example, with P1 and P2.

The auxiliary module 10 comprises a framework 11 with legs 12 the height of which can be adjusted to adapt to the height of the raised floor P, and feet 13 for resting on the ground. The framework 11 has a plurality of flat resting elements, which in the embodiment of the invention described herein are seven in number, which is to be understood is as a non-limiting example of the invention, and of these seven three are shown for the purposes of example, respectively 14, 15 and 16, where it is understood that such flat resting elements can also be different in number according to needs and requirements.

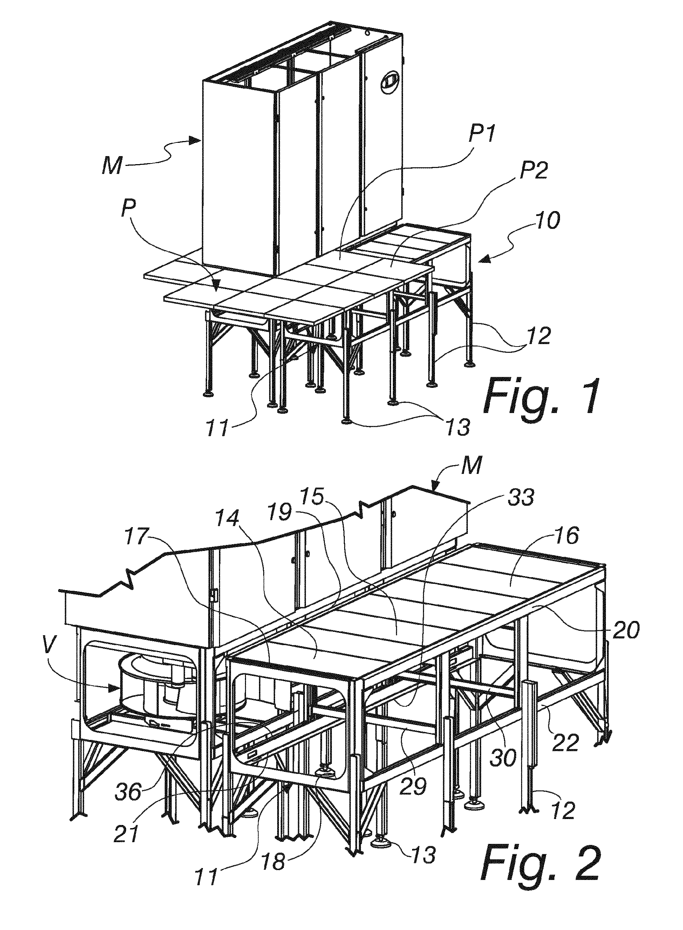

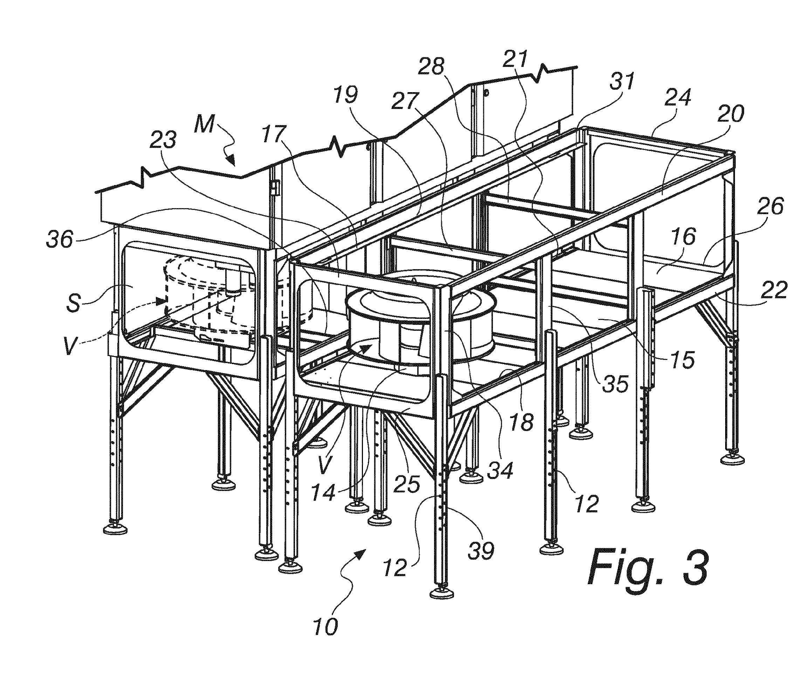

The framework 11 forms
- a first, upper, frame 17 for supporting the resting elements 14, 15 and 16; such first frame 17 is defined at a height that is such as to enable the corresponding flat resting elements 14, 15 or 16 to support one or more panels P1, P2 of the raised floor P, as in Figures 1 and 2;
- a second, lower, supporting frame 18, which is formed at a height that is intermediate between the first supporting frame 17 and the ground, a height that is such as to enable the resting on the flat resting elements 14, 15 and 16 of a fan V removed from its seat S under a climate control machine, as in Figure 3.

Each flat resting element 14, 15 and 16 is arrangeable on either one of the first and second supporting frames 17, 18.

Each flat resting element 14, 15 and 16 is comprised, for example, of a metallic grille or a metallic plate.

The supporting frames are each formed by corresponding pairs of opposite longitudinal members, 19 and 20 for the upper edges and 21 and 22 for the lower edges, of the framework 11, and by respective perimetric cross-members 23, 24, 25, 26.

Fixed between such pairs of longitudinal members are corresponding cross-members, as well as perimetric cross-members 23, 24, 25 and 26, and also internal cross-members 27, 28, 29 and 30.

Longitudinal members and cross-members can be made with metallic profiles or from folded sheet metal.

Such longitudinal members have a substantially L-shaped transverse cross-section, with the horizontal portion, for example 31 in Figure 3, and 33 in Figure 2, directed toward the inside of the framework so as to form the resting rim of the supporting frames 17 and 18 for the flat resting elements 14, 15 and 16.

The framework 11 has upright portions, for example 34 and 35 in Figure 3, between the upper and lower supporting frames, the ones on the side of the framework 11 which faces the fans V of the climate control machine M being arranged at such a mutual distance as to allow the passage of a fan V, of the associated climate control machine M, through a series of windows 36 which are formed between two consecutive upright portions and the corresponding upper and lower portions of the longitudinal members, for example the longitudinal members 19 and 21 for the window 36 in Figure 1.

The legs 12, of adjustable height, are each constituted by a bar which is fixed to a corresponding upright portion 35, and is provided in a downward region with a stem 39, which supports the foot 13 and can be extracted telescopically and locked with reversible locking means at a height selected from a plurality of different predefined heights.

Such reversible locking means should be understood as being of a conventional type.

The feet 13 can in turn be provided with a system of fine adjustment, for example of the screw type, which is understood to be of a conventional type and thus not shown for the sake of simplicity.

The use of the auxiliary module according to the invention is as follows.

Instead of the normal posts and feet for supporting the raised floor with which a climate control machine is associated that involves the positioning of a fan group under the raised floor, at the zone facing the machine an auxiliary module 10 according to the invention is positioned, with the flat resting elements 14, 15 and 16 positioned on the upper frame 17, so that they support the panels P1, P2 of the floor P.

In case work on the fans is required, it is sufficient to remove the panels of the floor in front of the climate control machine, take out the flat resting elements 14, 15 and 16 from the upper frame 17 and arrange them on the lower frame 18; then proceed to extract the fan, or fans, to be removed and for convenience they can be placed on the same resting elements 14, 15 and 16 which are in a favorable position for resting one or more fans thereon.

The operation of extraction, and of repositioning of the fans, is thus greatly simplified and does not involve the removal or reassembly of any post and/or of any floor-supporting foot.

In practice it has been found that the invention fully achieves the intended aim and objects.

In particular, with the invention an auxiliary module is provided which enables the quick and easy removal and repositioning of the bladed and motorized impeller part, without the inconvenient operations of disassembly and reassembly of posts and feet for supporting the raised floor.

Moreover, with the invention an auxiliary module is provided which frees the operator from having to work for a long period in uncomfortable positions.

Moreover, with the invention an auxiliary module is provided which can be easily associated with conventional frames of climate control machines and the like.

In addition, with the invention an auxiliary module is provided for facilitating the removal of fans of climate control machines with fans entirely or partially positioned under a raised floor, which can be made using known systems and technologies.

The invention, thus conceived, is susceptible of numerous modifications and variations, all of which are within the scope of the appended claims. Moreover, all the details may be substituted by other, technically equivalent elements.

In practice the materials employed, and the contingent dimensions and shapes, may be any according to requirements and to the state of the art.

The disclosures in Italian Patent Application No. PD2011A000345 from which this application claims priority are incorporated herein by reference.

Where technical features mentioned in any claim are followed by reference signs, such reference signs have been inserted for the sole purpose of increasing the intelligibility of the claims and accordingly such reference signs do not have any limiting effect on the interpretation of each element identified by way of example by such reference signs.

## Claims

1. An auxiliary module (10) for raised floors for removing fans, arranged under the floor, of climate control machines, **characterized in that** it comprises
- a framework (11) with legs (12) the height of which can be adjusted to adapt to the height of a raised floor (P), and feet (13) for resting on the ground,
- and at least one flat resting element (14),
said framework forming
- a first frame (17) for supporting said at least one, upper, flat resting element (14), which is formed at such a height as to allow said flat resting element (14) to support one or more panels (P1, P2) of a raised floor (P)
- a second, lower, supporting frame (18), which is formed at a height that is intermediate between the first supporting frame (17) and the ground, so as to allow the resting on said flat resting element (14) of a fan (V) removed from its seat (S) below a climate control machine (M),
said at least one flat resting element (14) being arrangeable on either one of said first and second supporting frames (17, 18).

2. The auxiliary module according to claim 1, **characterized in that** said flat resting element (14) is constituted by a metallic grille or a metallic plate.

3. The auxiliary module according to one or more of the preceding claims, **characterized in that** said supporting frames (17, 18) each comprise corresponding pairs of opposite longitudinal members (19, 20, 21, 22) of said framework (11) and respective perimetric cross-members (23, 24, 25, 26).

4. The auxiliary module according to one or more of the preceding claims, **characterized in that** the longitudinal members and the cross-members have a substantially L-shaped transverse cross-section, with the horizontal portion directed toward the inside of the framework so as to form the resting rim (31, 33) of said supporting frames (17, 18) for said flat resting element (14).

5. The auxiliary module according to one or more of the preceding claims, **characterized in that** said framework (11) is provided with upright portions (34, 35) between the upper supporting frame (17) and the lower supporting frame (18), which, on at least one side of said framework (11), are arranged at such a mutual distance as to allow the passage of a fan (V) of an associated climate control machine (M) through a window (36) defined between two consecutive upright portions and the corresponding upper and lower portions of the longitudinal members.

6. The auxiliary module according to one or more of the preceding claims, **characterized in that** said legs (12) of adjustable height are each constituted by a bar which is fixed to a corresponding upright portion (34, 35) and is provided in a downward region with a foot supporting stem (39) which can be extracted telescopically and locked with reversible locking means at a height selected from a plurality of different predefined heights.
